# EUROPEAN PATENT APPLICATION

(11) **EP 2 096 661 A1**
(43) Date of publication of application: **02.09.2009**
(21) Application number: 09002528.9
(22) Date of filing: 23.02.2009
(51) Int. Cl.: H01J 37/073, H01J 37/26

(54) **Cold cathode field emission electron gun and its application to electron beam instruments**

(30) Priority: 27.02.2008 JP 2008046126
(71) Applicant: Hitachi High-Technologies Corporation, Minato-ku Tokyo 105-8717 (JP)
(72) Inventor: Tamura, Keiji, Ibaraki 312-8504 (JP); Watanabe, Shun-ichi, Ibaraki 312-8504 (JP); Onishi, Takashi, Ibaraki 312-8504 (JP)
(74) Representative: Strehl Schübel-Hopf & Partner

(57) **Abstract**

The present invention provides an electron beam instrument in which variation of the trajectory of the electron beams can be suppressed even when the voltage applied to the first extractor electrode (2) is controlled in order to stabilize the emission current amount of the electron beams. The electron beam instrument has a cold cathode field emission electron gun. The cold cathode field emission electron gun has a cold cathode (1), a first extractor electrode (2) and a second extractor electrode (3). Distance (L1) between the cold cathode and the first extractor electrode is set to be shorter than distance (L2) between the first extractor electrode and the second extractor electrode. Voltage (V1) applied to the first extractor electrode is increased when current amount of the electron beams emitted from the cold cathode is attenuated.

## Description

### BACKGROUND OF THE INVENTION

### 1. Field of the Invention

The present invention relates to a cold cathode field emission electron gun and its application to electron beam instruments.

### 2. Description of the Related Art

A cold cathode field emission (CFE) electron gun is a high brightness electron gun which is widely utilized for electron beam instruments such as a Transmission Electron Microscope (TEM), a Scanning Electron Microscope (SEM) and a Scanning Transmission Electron Microscope (STEM). Typically, a CFE electron gun includes a cold cathode, a first extractor electrode, a second extractor electrode, and an acceleration tube. When an intensive electric field is applied to the cold cathode by the first extractor electrode, electron beams are emitted from the cold cathode. The emitted electron beams are condensed by an electrostatic lens which is formed between the first extractor electrode and the second extractor electrode and accelerated by the acceleration tube up to the necessary energy.

The cold cathode electron gun has a characteristic that the emission amount of the electron beams decreases in accordance with operation time. In order to stabilize the emission amount of the electron gun, voltage applied to the first extractor electrode needs to be controlled to increase.

Here, when the voltage applied to the first extractor electrode is changed, the trajectory of the electron beams varies. For example, a condensing position of the electron beams varies considerably. Therefore, voltage of the second extractor electrode and magnetic excitation of a subsequent condenser lens need to be changed.

In this manner, when the voltage applied to the first extractor electrode is changed, optical operation conditions of the CFE electron gun need to be controlled, and then, the operation becomes complicated. Further, when the voltage applied to the first extractor electrode is changed, there is a case that the radiation position and the size of the electron beams vary under the influence of optical axis shifting and the like. Therefore, stability and operability of the cold cathode field emission are decreased.

This characteristic is the same in the case that a virtual crossover is formed. Namely, it is the case that a real crossover is not formed by suppressing the electrostatic lens action which is generated between the first extractor electrode and the second extractor electrode and the virtual crossover is formed at a position above the cathode.

An object of the present invention is to provide an electron beam instrument in which variation of the trajectory of the electron beams can be suppressed even when the voltage applied to the first extractor electrode is controlled in order to stabilize the emission current amount of the electron beams.

### SUMMARY OF THE INVENTION

The electron beam instrument of the present invention includes a cold cathode field emission electron gun, a condenser lens which condenses electron beams from the cold cathode field emission electron gun, and an objective lens which condenses the electron beams from the condenser lens onto a specimen. The cold cathode field emission electron gun includes a cold cathode, a first extractor electrode having a bore at its center, a second extractor electrode having a bore at its center, and an acceleration tube.

In the present invention, the distance between the cold cathode and the first extractor electrode is set to be shorter than the distance between the first extractor electrode and the second extractor electrode. Then, when the current amount of the electron beams emitted from the cold cathode is attenuated, the voltage applied to the first extractor electrode is increased.

With the present invention, variation of the trajectory of the electron beams can be suppressed even when the voltage applied to the first extractor electrode is controlled in order to stabilize the emission current amount of the electron beams.

### DESCRIPTION OF DRAWINGS

FIG. 1 is a diagram which illustrates a structural example of an electron beam instrument having a cold cathode field emission electron gun of the present invention;
FIG. 2 is a graph which explains variation with time of current amount of electron beams of the cold cathode field emission electron gun;
FIG. 3 is a graph which explains the relation between first extractor voltage and the current amount of the electron beams of the cold cathode field emission electron gun;
FIG. 4 is a graph which shows the relation between the first extractor voltage and a virtual crossover position of the conventional cold cathode field emission electron gun;
FIG. 5 is a graph which shows the relation between the first extractor voltage and the virtual crossover position when the distance between the cold cathode and first extractor electrode is changed;
FIG. 6 is a graph which shows the relation between the first extractor voltage and the virtual crossover position when the distance between the two extractor electrodes is changed;
FIG. 7 is a graph which shows the relation between the first extractor voltage and the virtual crossover position when the bore diameter of the second extractor electrode is changed;
FIG. 8 is a flowchart which shows the flow of automatic control of the current amount of the electron beams of the cold cathode field emission electron gun of the present invention; and
FIG. 9 is a view which shows an example of a setting screen of the control of the current amount of the electron beams of the cold cathode field emission electron gun of the present invention.

### DESCRIPTION OF PREFERRED EMBODIMENT

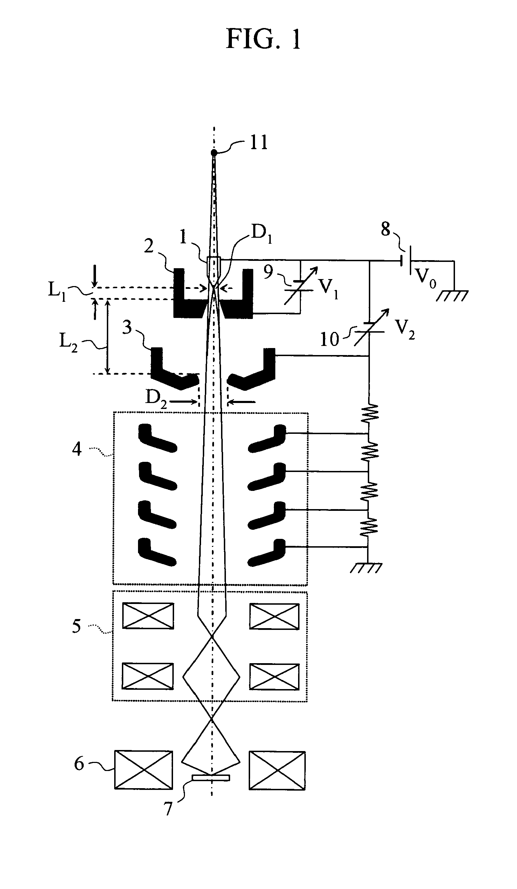

An embodiment of the electron beam instrument of the present invention is explained with reference to FIG. 1. The electron beam instrument of the present embodiment includes a cold cathode field emission (CFE) electron gun, a condenser lens 5 and a polepiece 6. The cold cathode field emission electron gun includes a cold cathode 1, a first extractor electrode 2, a second extractor electrode 3 and an acceleration tube 4. The cold cathode 1 has a pointed top end. The first extractor electrode 2 has a bore, the inner diameter of which is D1. The second extractor electrode 3 has a bore, the inner diameter of which is D2. The magnetic field which is generated by the polepiece 6 forms an objective lens.

Acceleration voltage V0 is applied to the cold cathode 1 from an acceleration voltage power source 8. First extractor voltage V1 is applied between the cold cathode 1 and the first extractor electrode 2 from a first extractor electrode power source 9. Second extractor voltage V2 is applied between the cold cathode 1 and the second extractor electrode 3 from a second extractor electrode power source 10. Acceleration voltage is applied to the acceleration tube 4 from the acceleration voltage power source 8. The first extractor voltage V1 which is applied to the first extractor electrode 2 and the second extractor voltage V2 which is applied to the second extractor electrode 3 are variable.

The electron beams are emitted from the cold cathode 1 by applying the first extractor voltage V1 to the cold cathode 1. The electron beams are condensed by an electrostatic lens which is formed between the first extractor electrode 2 and the second extractor electrode 3. The condensed electron beams are accelerated by the acceleration tube 4 eventually up to the energy of about 200 kV. The electron beams are condensed by the condenser lens 5 and condensed by the objective lens which is formed by the polepiece 6 so as to be focused onto a specimen 7.

In this case, the virtual illuminant position of the accelerated electron beams, namely, the virtual crossover 11, is located above the cold cathode 1. The position of the virtual crossover 11 is affected by the condensing action of the electrostatic lens which is formed by the first extractor electrode 2 and the second extractor electrode 3.

With the cold cathode electron gun, the current amount of the electron beams emitted from the cold cathode 1 varies with time. That is, the current amount of the electron beams is attenuated with time. Therefore, in order to maintain the current amount of the electron beams constant, the first extractor voltage V1 needs to be increased. When the first extractor voltage V1 is increased, the condensing action of the electrostatic lens varies and the position of the virtual crossover 11 varies. With the conventional CFE electron gun, in order to suppress the position variation of the virtual crossover, it has been needed to change the second extractor voltage V2 corresponding to the first extractor voltage V1 along with increasing the first extractor voltage V1. Further, magnetic excitation of the condenser lens 5 has been necessary to be changed. Therefore, the control has been complicated.

With the CFE electron gun of the present embodiment, the distance L1 between the cold cathode 1 and the first extractor electrode 2 is set to be relatively short. Further, the distance L2 between the first extractor electrode 2 and the second extractor electrode 3 is set to be relatively long. Therefore, the ratio of the distance L2 between the first extractor electrode 2 and the second extractor electrode 3 against the distance L1 between the cold cathode 1 and the first extractor electrode 2 becomes large. For example, the ratio of the distance L2 against the distance L1 is set to be between 1 and 5, preferably between 2 and 5. Thus, the position of the virtual crossover 11 hardly varies even when the first extractor voltage V 1 is increased.

First, the meaning of relatively shortening the distance L1 between the cold cathode 1 and the first extractor electrode 2 is explained. The current amount of the electron beams from the CFE electron gun is dependent on the electric field intensity at the vicinity of the top end of the cold cathode. The electric field intensity is considerably changed in accordance with the radius of curvature of the top end of the cold cathode and the first extractor voltage. On the contrary, even when the distance between the cold cathode and the first extractor electrode is changed, the variation of the electric field intensity at the vicinity of the top end of the cold cathode is small. Therefore, even when the distance between the cold cathode and the first extractor electrode is changed, the current amount of the electron beams from the CFE electron gun does not vary significantly.

In the CFE electron gun of the present embodiment, the distance L1 between the cold cathode and the first extractor electrode is shortened. Further, the second extractor voltage is controlled so that the virtual crossover is formed at the position above the cold cathode. Accordingly, the position of the virtual crossover hardly varies even when the first extractor voltage is changed. This is specifically explained later.

Next, the meaning of relatively lengthening the distance L2 between the first extractor electrode 2 and the second extractor electrode 3 is explained. The condensing action of the electrostatic lens which is formed by the first extractor electrode and the second extractor electrode varies in accordance with the distance L2 between the two extractor electrodes. When the distance L2 between the two extractor electrodes is lengthened, the condensing action of the electrostatic lens is decreased and magnification ratio of the electrostatic lens is decreased. In the case that the condensing action of the electrostatic lens is decreased, the position of the virtual crossover hardly varies even when the first extractor voltage is changed. Here, the distance L2 between the first extractor electrode and the second extractor electrode is lengthened so that the spreading angle of the electron beams is to be within the allowable range. Accordingly, the stability of the electron gun is ensured even when the first extractor voltage is changed.

In the CFE electron gun of the present embodiment, the bore diameter of the second extractor electrode is set to be relatively large. With this structure, the effects similar to the case of relatively lengthening the distance L2 between the two extractor electrodes can be obtained. That is, the condensing action of the electrostatic lens which is formed between the two extractor electrodes is decreased. Therefore, the magnification ratio of the electrostatic lens is decreased. Here, the position of the virtual crossover hardly varies even when the first extractor voltage is changed.

With the present invention, the desired effects can be obtained due to the structure of relatively shortening the distance L1 between the cold cathode 1 and the first extractor electrode 2. Further, it is also possible to combine the structure of relatively lengthening the distance L2 between the first extractor electrode 2 and the second extractor electrode 3. Further, it is also possible to combine the structure of relatively enlarging the bore diameter of the second extractor electrode 3 with the structure of relatively shortening the distance L1 between the cold cathode 1 and the first extractor electrode 2. Furthermore, it is also possible to combine these three structures.

With the CFE electron gun of the present embodiment, the second extractor voltage V2 can be constant when the first extractor voltage V1 is increased. Alternatively, the second extractor voltage V2 can be increased along with the first extractor voltage V1. For example, the second extractor voltage V2 can be controlled so that the ratio of the second extractor voltage V2 against the first extractor voltage V1 is to be constant.

With the CFE electron gun of the present invention, the condensing action of the electrostatic lens which is formed by the two extractor electrodes is suppressed. Therefore, the CFE electron gun of the present invention has a characteristic that the spherical aberration coefficient and the chromatic aberration coefficient are lower than those of the conventional CFE electron gun. With the CFE electron gun of the present invention, the spherical aberration coefficient and the chromatic aberration coefficient in object point conversion is improved respectively to one-half and two-thirds being compared with the conventional CFE electron gun.

With the CFE electron gun of the present invention, the current amount of the electron beams can be controlled without changing the magnetic excitation of the subsequent condenser lens. Therefore, it becomes possible to improve the stability and the operability of the electron gun.

In the present invention, the distance L1 between the cold cathode 1 and the extractor electrode 2 is shortened and the distance L2 between the first extractor electrode 2 and the second extractor electrode 3 is relatively lengthened. Here, it is also possible to change only the position of the first extractor electrode 2 without changing the positions of the cold cathode 1 and the second extractor electrode 3. Further, it is also possible to change at least one position among the positions of the cold cathode 1, the first extractor electrode 2 and the second extractor electrode 3.

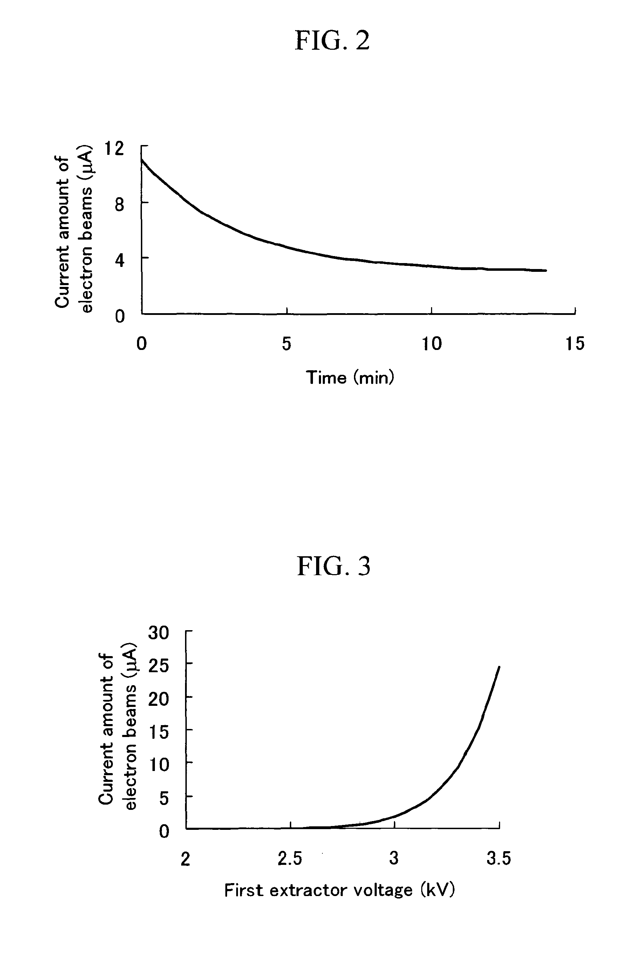

FIG. 2 is a graph which shows an example of variation with time of the emission current of the cold cathode electron gun. The horizontal axis is for the time and the vertical axis is for the current amount (µA) of the electron beams emitted from the cold cathode. The cold cathode electron gun has a characteristic that the emission amount of the electron beams is attenuated with time under the influence of gas molecules around the cold cathode. The attenuation speed of the emission amount of the electron beams is dependent on the gas modular mass around the cold cathode. Therefore, with the cold cathode electron gun, the voltage of the first extractor electrode needs to be adjusted in order to maintain the emission current constant.

FIG. 3 is a graph which shows an example of the relation between the first extractor voltage and the current amount of the electron beams emitted from the cold cathode. The horizontal axis is for the first extractor voltage (kV) and the vertical axis is for the current amount (µA) of the electron beams emitted from the cold cathode. With the cold cathode electron gun, the current amount of the electron beams is increased when the first extractor voltage is increased within the range of 2.5 kV to 3.5 kV.

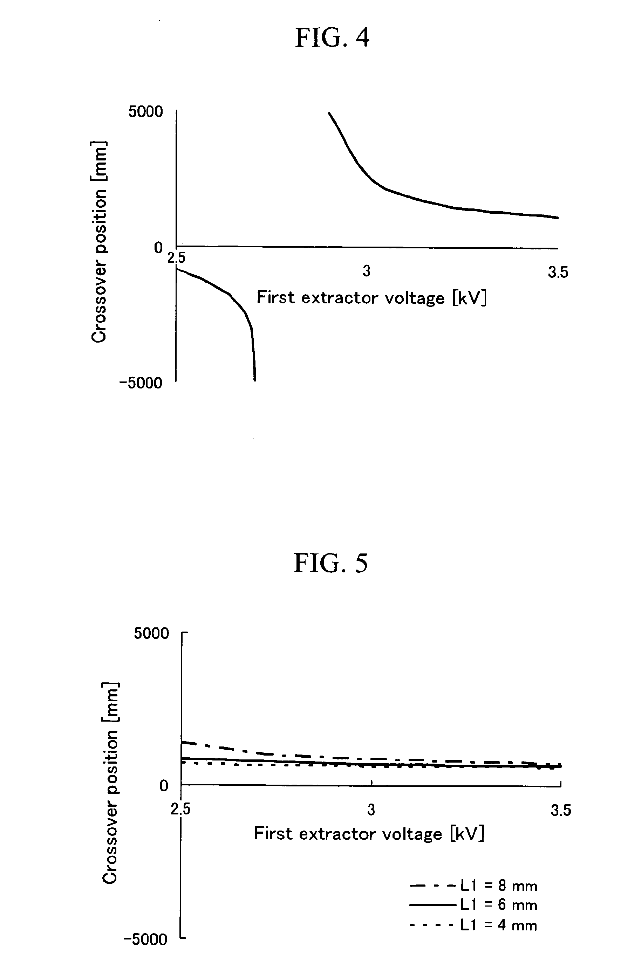

FIG. 4 is a graph which shows an example of the relation between the first extractor voltage and the virtual crossover position of the conventional CFE electron gun. The horizontal axis is for the first extractor voltage (kV) and the vertical axis is for the crossover position (mm). The crossover position is the distance to the virtual crossover 11 from the origin point which is the center of the upper lens of the condenser lens 5. The focal distance is positive when the virtual crossover is located above the cold cathode. The focal distance is negative when the real crossover is located below the cold cathode. The distance L1 between the cold cathode and the first extractor electrode is 11 mm and the distance L2 between the two extractor electrodes is 17 mm. The bore diameter D2 of the second extractor electrode is 6 mm.

The graph shows that the virtual crossover position is lowered when the first extractor voltage is increased within the range of about 2.9 kV to 3.5 kV. When the first extractor voltage is decreased, the virtual crossover position is heightened. Then, when the first extractor voltage is decreased to be lower than about 2.9 kV, the virtual crossover diverges. Further, the real crossover, not being the virtual crossover, is formed below the cold cathode when the first extractor voltage is decreased to be lower than a predetermined value. In this manner, the crossover position varies drastically when the first extractor voltage is changed.

FIG. 5 is a graph which shows the relation between first extractor voltage and the virtual crossover position in the case that the distance L1 between the cold cathode and the first extractor electrode is relatively shortened. The horizontal axis is for the first extractor voltage (kV) and the vertical axis is for the crossover position (mm). Here, the relations between the first extractor voltage and the virtual crossover position are acquired in three cases that the distance L1 between the cold cathode and the first extractor electrode is respectively 4 mm, 6 mm and 8 mm. Namely, in every case, the distance L1 is shorter than that of the case of the conventional CFE electron gun (L1 = 11 mm). The rest of the dimensions is the same as the conventional CFE electron gun. Specifically, the distance L2 between the two extractor electrodes is 17 mm and the bore diameter D2 of the second extractor electrode is 6 mm.

When the distance L1 between the cold cathode and the first extractor electrode is relatively shortened, the variation amount of the virtual crossover position becomes extremely small compared with the case of the conventional CFE electron gun in FIG. 4. When the distance L1 is relatively shortened further, the virtual crossover position remains almost invariant within the operation range of the cold cathode field emission electron gun. Thus, when the distance L1 between the cold cathode and the first extractor electrode is set to be shorter than that of the conventional CFE electron gun, the virtual crossover position varies in small amount and becomes almost invariant.

When comparing the three curve lines, that is, when comparing the cases that the distance L1 is respectively 4 mm, 6mm and 8 mm, it turns out that the shorter the distance L1 is, the smaller the variation amount of the virtual crossover position is. The gas molecules are affected by the incidence of the electron beams to the extractor electrode. In order to obtain stable emission characteristics, it is not preferable that the distance L1 between the cold cathode and the first extractor electrode is too short. Therefore, it is preferable that the distance L1 between the cold cathode and the first extractor electrode is within the range of 4 to 8mm.

As mentioned above, in the CFE electron gun of the present invention, the distance L1 between the cold cathode and the first extractor electrode is set to be shorter than that of the conventional CFE electron gun. For example, the distance L1 between the cold cathode and the first extractor electrode is set to be within the range of 4 to 8 mm.

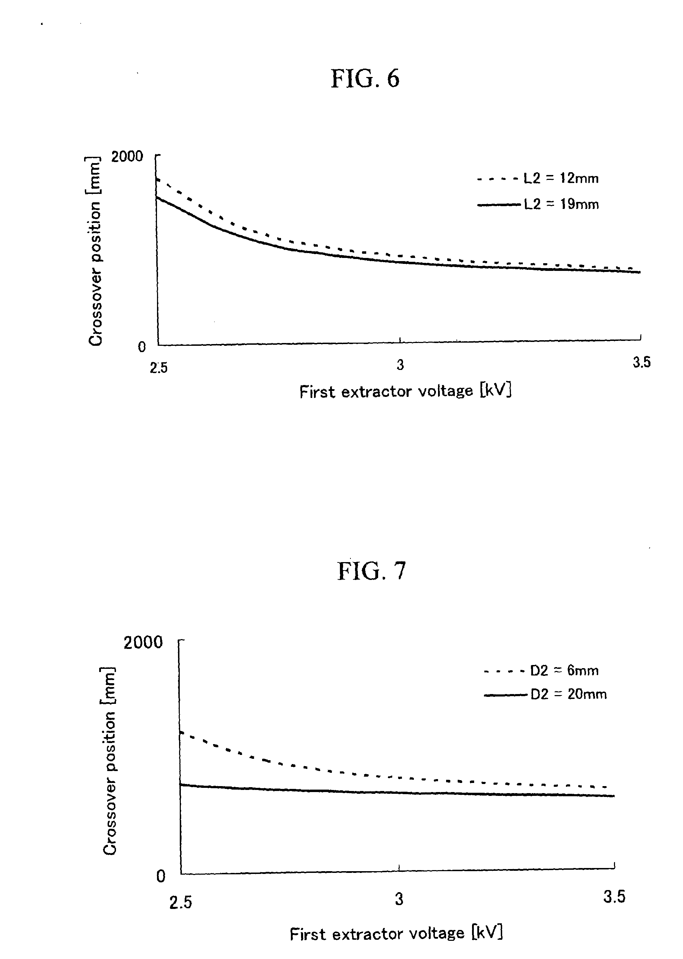

FIG. 6 is a graph which shows the relation between the first extractor voltage and the virtual crossover position in the case that the distance L2 between the two extractor electrodes is changed. The horizontal axis is for the first extractor voltage (kV) and the vertical axis is for the crossover position (mm). Here, the relations between the first extractor voltage and the virtual crossover position are acquired in two cases that the distance L2 between the two extractor electrodes is respectively 12 mm and 19 mm. Namely, one case is that the distance L2 between the two extractor electrodes is shorter than that of the conventional CFE electron gun (L2 = 17 mm), the other is that the distance L2 between the two extractor electrodes is longer than that of the conventional CFE electron gun (L2 = 17 mm). Here, the distance L1 between the cold cathode and the first extractor electrode is 6 mm and the bore diameter D2 of the second extractor electrode is 6 mm. Consequently, the distance L2 between the two extractor electrodes is changed while the distance L1 between the cold cathode and the first extractor electrode is relatively shortened.

With the present embodiment, the variation amount of the virtual crossover position is extremely smaller than that of the conventional CFE electron gun which is shown in FIG. 4. As can be seen, in the case that the distance L1 between the cold cathode and the first extractor electrode is set to be short, the variation amount of the virtual crossover position becomes small in both cases that the distance L2 between the two extractor electrodes is lengthened and that the distance L2 is shortened.

Further, as can be seen in FIG. 6, the virtual crossover position is lowered when the first extractor voltage is increased. When comparing the cases that the distance L2 is 12 mm and that the distance L2 is 19 mm, the longer the distance L2 is, the smaller the variation amount of the virtual crossover position is.

FIG. 7 is a graph which shows the relation between the first extractor voltage and the virtual crossover position in the case that the bore diameter D2 of the second extractor electrode is changed. The horizontal axis is for the first extractor voltage (kV) and the vertical axis is for the crossover position (mm). Here, the relations between the first extractor voltage and the virtual crossover position are acquired in two cases that the bore diameter D2 of the second extractor electrode is respectively 6 mm and 12 mm. Namely, they are the cases that the bore D2 diameter of second extractor electrode is respectively equal to and larger than that of the conventional CFE electron gun (D2 = 6 mm). Here, the distance L1 between the cold cathode and the first extractor electrode is 6 mm and the distance L2 between the two extractor electrodes is 17 mm. Consequently, the bore diameter D2 is changed while the distance L1 between the cold cathode and the first extractor electrode is relatively shortened.

With the present embodiment, the variation amount of the virtual crossover position is extremely smaller than that of the conventional CFE electron gun which is shown in FIG. 4. Thus, in the case that the distance L1 between the cold cathode and the first extractor electrode is shortened and the bore diameter D2 of the second extractor electrode is enlarged further, the virtual crossover position varies in small amount and becomes almost invariant.

As mentioned above, in the CFE electron gun of the present invention, the bore diameter D2 of the second extractor electrode is set to be larger than that of the conventional CFE electron gun. For example, the bore diameter D2 of the second extractor electrode is set to be within the range of 10 to 15 mm.

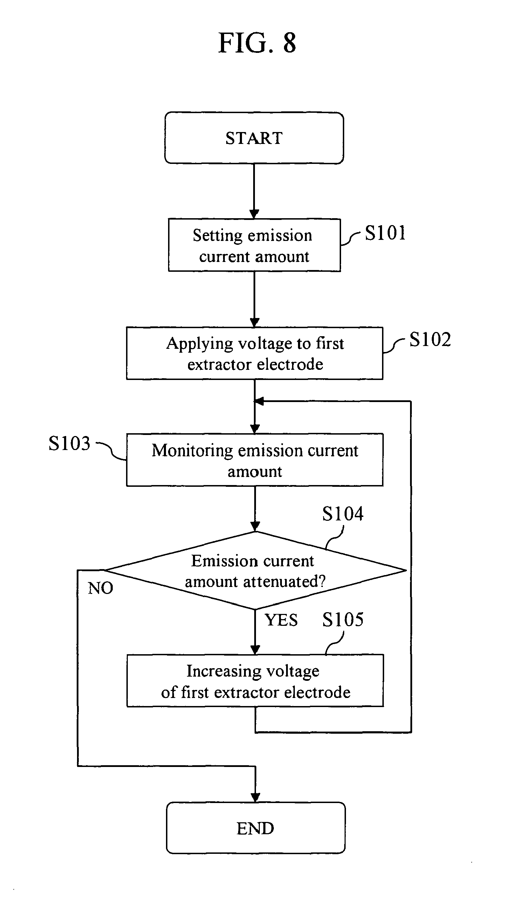

An example of a method of automatic control of the current amount of the electron beams of the CFE electron gun of the present invention is explained with reference to FIG. 8. In step S101, the current amount of the electron beams emitted from the cold cathode is set. In step S 102, the first extractor voltage V1 is applied to the first extractor electrode. In step S 103, the current amount of the electron beams emitted from the cold cathode is monitored. In step S 104, the current amount of the electron beams is determined whether or not it is attenuated. When the current amount of the electron beams is determined to be attenuated, proceeds to step S105. In step S 105, the first extractor voltage V1 to the first extractor electrode is increased, and then, returns to step S103. When the current amount of the electron beams is determined not to be attenuated in step S 104, the process ends.

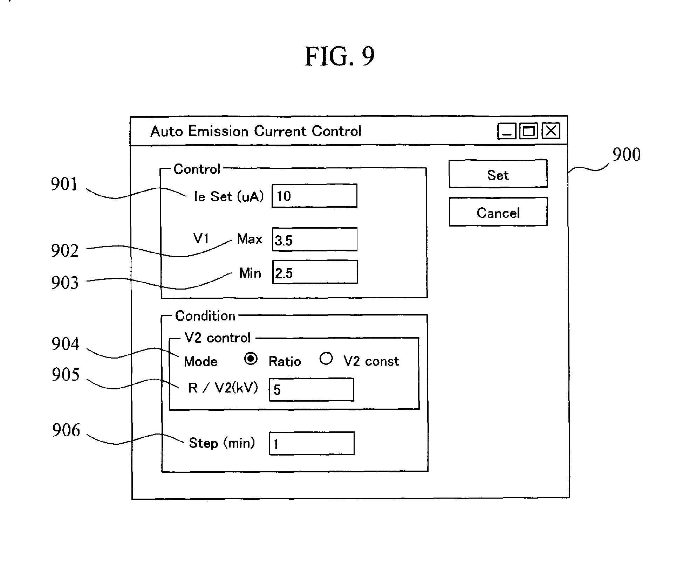

FIG. 9 shows an example of a control screen of the CFE electron gun of the present invention. The control screen 900 includes a field 901 for setting the current amount (µA) of the electron beams, a field 902 for setting the maximum value of the first extractor voltage, a field 903 for setting the minimum value of the first extractor voltage, a button 904 for selecting a setting mode of the second extractor voltage, a field 905 for setting the ratio, and a field 906 for setting the time step. The button 904 can select either that the second extractor voltage is set by the ratio against the first extractor voltage or that the second extractor voltage is set by a value. In the case of being set by the ratio, the ratio is set in the field 905.

In the above, an embodiment of the present invention is explained. However, the present invention is not limited to the embodiment. It is easily understood for a person skilled in the art that various modifications can be performed within the scope of the invention described in the claims.

### Description of reference numerals

1 Cold cathode
2 First extractor electrode
3 Second extractor electrode
4 Acceleration tube
5 Condenser lens
6 Polepiece
7 Specimen
8 Acceleration voltage power source
9 First extractor electrode power source
10 Second extractor electrode power source
11 Virtual crossover of electron beams

## Claims

1. An electron beam instrument comprising:
a cold cathode field emission electron gun;
a condenser lens which condenses electron beams from the cold cathode field emission electron gun; and
an objective lens which condenses the electron beams from the condenser lens onto a specimen;
wherein the cold cathode field emission electron gun comprises a cold cathode, a first extractor electrode having a bore at the center thereof, a second extractor electrode having a bore at the center thereof, and an acceleration tube;
wherein distance between the cold cathode and the first extractor electrode is set to be shorter than distance between the first extractor electrode and the second extractor electrode; and
wherein voltage applied to the first extractor electrode is increased when current amount of the electron beams emitted from the cold cathode is attenuated.

2. The electron beam instrument according to claim 1, wherein a virtual crossover which is formed by the electron beams emitted from the cold cathode is located on the optical axis of the cold cathode at a position of the opposite side to the travelling direction of the electron beams.

3. The electron beam instrument according to claim 1, wherein the ratio of the distance L1 between the cold cathode and the first extractor electrode against the distance L2 between the first extractor electrode and the second extractor electrode is set to be between 1 and one-fifth.

4. The electron beam instrument according to claim 1, wherein the distance L1 between the cold cathode and the first extractor electrode is set to be within the range of 4 to 8 mm.

5. The electron beam instrument according to claim 1, wherein voltage applied to the second extractor electrode is constant when the voltage applied to the first extractor electrode is increased.

6. The electron beam instrument according to claim 1, wherein voltage applied to the second extractor electrode is also increased when the voltage applied to the first extractor electrode is increased.

7. The electron beam instrument according to claim 1, wherein voltage applied to the second extractor electrode is increased so that the ratio of the voltage applied to the second extractor electrode against the voltage applied to the first extractor electrode is to be constant when the voltage applied to the first extractor electrode is increased.

8. The electron beam instrument according to claim 1, wherein the inner diameter of the bore of the second extractor electrode is larger than the inner diameter of the bore of the first extractor electrode.

9. The electron beam instrument according to claim 1, wherein the inner diameter of the bore of the second extractor electrode is set to be within the range of 10 to 15 mm.

10. A cold cathode field emission electron gun, comprising:
a cold cathode which has a pointed top end;
a first extractor electrode which is arranged along the optical axis of the cold cathode and which has a bore at the center thereof;
a second extractor electrode which is arranged along the optical axis of the cold cathode and which has a bore at the center thereof;
a first extractor electrode power source which variably applies first extractor voltage between the cold cathode and the first extractor electrode;
a second extractor electrode power source which variably applies second extractor voltage between the cold cathode and the second extractor electrode;
an acceleration voltage power source which applies acceleration voltage to the cold cathode; and
an acceleration tube;
wherein distance between the cold cathode and the first extractor electrode is set to be shorter than distance between the first extractor electrode and the second extractor electrode; and
wherein the first extractor voltage is increased when current amount of electron beams emitted from the cold cathode is attenuated.

11. The cold cathode field emission electron gun, according to claim 10, wherein a virtual crossover which is formed by the electron beams emitted from the cold cathode is located on the optical axis of the cold cathode at a position of the opposite side to the travelling direction of the electron beams.

12. The cold cathode field emission electron gun, according to claim 10, wherein the ratio of the distance L1 between the cold cathode and the first extractor electrode against the distance L2 between the first extractor electrode and the second extractor electrode is set to be between 1 and one-fifth.
